Europäisches Patentamt

European Patent Office

Office européen des brevets

(11) Veröffentlichungsnummer: **0 459 506 A1**

# EUROPÄISCHE PATENTANMELDUNG

(21) Anmeldenummer: **91108917.5**

(22) Anmeldetag: **31.05.91**

(51) Int. Cl.5: **H04R 3/00**, H03G 1/00, H03G 3/20

(30) Priorität: **31.05.90 DE 4017506**

(43) Veröffentlichungstag der Anmeldung:
**04.12.91 Patentblatt 91/49**

(84) Benannte Vertragsstaaten:
**AT BE CH DE ES FR GB LI NL**

(71) Anmelder: **SENNHEISER ELECTRONIC KG
Wennebostel
W-3002 Wedemark(DE)**

(72) Erfinder: **Niehoff, Wolfgang, Dr.-Ing.
Am Simonsberg 3
W-3002 Wedemark(DE)**
Erfinder: **Rhenius, Volker, Dipl.-Ing.
Lohwiesenring 30
W-3002 Wedemark(DE)**
Erfinder: **Baumscheiper, Martin, Dipl.-Ing.
Wöhlerstrasse 12
W-3000 Hannover(DE)**

(54) **Schaltungsanordnung zur Begrenzung der Lautstärke.**

(57) Eine Schaltungsanordnung begrenzt die Lautstärke eines dynamischen Wiedergabewandlers mittels eines diesem vorgeschalteten passiven Dämpfungsnetzwerks mit mindestens einem temperaturabhängigen Widerstand. Erfindungsgemäß ist sie dadurch gekennzeichnet, daß der von der Lautstärke und der Einwirkungszeit derselben abhängige Dämpfungsverlauf des Dämpfungsnetzwerks eine Zeitkonstante aufweist, welche durch die Wärmespeicherkapazität des temperaturabhängigen Widerstandes (2) selbst oder durch ein mit demselben thermisch gekoppeltes wärmespeicherndes Medium (4) gebildet wird. Eine zweckmäßige Anwendung der Schaltungsanordnung ist für einen Stereokopfhörer beschrieben.

Fig. 1

Die Erfindung bezieht sich auf eine Schaltungsanordnung zur Begrenzung der Lautstärke eines dynamischen Wiedergabewandlers mittels eines diesem vorgeschalteten Dämpfungsnetzwerkes mit mindestens einem temperaturabhängigen Widerstand. Dynamische Wiedergabewandler, über einen geeigneten Bügel zu einem Kopfhörer ergänzt, ermöglichen durch ihre gute akustische Ankopplung einen hohen Schalldruckpegel am Ohr. Im Gegensatz zu Lautsprechern stört dabei diese hohe Lautstärke die Umgebung wenig, und es wird deshalb oft über längere Zeiträume mit einem hohen Schalldruck abgehört. Insbesondere bei Kassettenabspielgeräten, aber auch bei der Qualitätskontrolle in Aufnahmestudios oder bei Tonträgerherstellern wird meistens ein sehr hoher Schalldruck genutzt, der bis zu 100 dB (A) und mehr betragen kann. Die zulässige Einwirkungszeit von Schalldruckpegeln größer als 80 dB (A) ist in Normen festgeschrieben, die aufgrund des Lärmschadenaufkommens und der zeitweisen Hörschwellenverschiebung - TTS des Gehörs festgelegt worden sind. Hiernach bedingen größere Abhörpegel kürzerer Einwirkzeiten und umgekehrt. Werden diese festgelegten Abhörpegel überschritten, so kann es zu Schädigungen des Gehörs kommen.

Die Lautstärke eines Wandlers kann begrenzt werden, indem einerseits die Ausgangsleistung des vorgeschalteten Gerätes beispielsweise eines Verstärkers oder andererseits die Aufnahmeleistung des Wandlers begrenzt wird. Es empfiehlt sich jedoch nicht, die Begrenzung an der Audioquelle vorzunehmen, da durch die unterschiedlichen Impedanzen und Wirkungsgrade der Wandler eine zu unterschiedliche Begrenzung auftreten würde. Es muß also eine wandlerbezogene Begrenzung der Lautstärke direkt an dem jeweiligen Wandlersystem vorgesehen werden. Auch sollte keine zusätzliche Hilfsenergiequelle - Versorgungsspannung - benötigt werden, um die Kopfhörer unbeschränkt aus allen denkbaren Audio-Quellen und deren Anschlußbuchsen speisen zu können.

Die einfachste bekannte Schaltungsanordnung zur Begrenzung der Lautstärke in der Art des sogenannten Knack- oder Puzzles-Schutzes besteht in der Parallelschaltung von spannungsabhängigen Widerständen zum Wandlersystem. Vorzugsweise werden dafür Dioden oder Zener-Dioden eingesetzt, welche jedoch beim Überschreiten der festgelegten Lautstärke starke hörbare Verzerrungen verursachen.

Eine weitere bekannte Schaltungsanordnung sieht den Einsatz von temperaturabhängigen Widerständen mit kurzer Ansprechdauer vor. In der Deutschen Offenlegungsschrift 22 03 002 werden Glühlampen in den Brückenzweigen einer Vollbrük- ke eingesetzt, wodurch die Lautstärke des in der Brückendiagonale angeordneten Wandlersystems begrenzt wird. Der Dynamikbereich der Wiedergabe wird jedoch hiermit deutlich eingeschränkt.

Diese bisher bekannt gewordenen passiven Schaltungen beschränken sich in ihrer Wirkung auf eine Begrenzung des maximalen Abhörpegels ohne daß dessen Einwirkdauer auf das Gehör berücksichtigt wird.

Der Erfindung liegt daher die Aufgabe zugrunde, die Lautstärke eines Kopfhörers bzw. dessen Wandlersysteme so zu begrenzen, daß keine gehörgefährdenden Pegel, welche von der Einwirkzeit abhängig und durch die TTS-Kurven vorgegeben sind, auftreten können. Die Nachteile der bekann- ten Schaltungsanordnungen wie im Begrenzungs- bereich auftretende Verzerrungen oder eine vorzeitige Begrenzung und Einengung des Dynamikbereichs bei kurzen Einwirkzeiten sollen vermieden werden.

Die Aufgabe wird mit einer Schaltungsanordnung entsprechend dem Oberbegriff des Patentanspruchs 1 erfindungsgemäß mit den im Kennzeichen desselben genannten Merkmalen gelöst. Vorteilhafte Ausgestaltungen der Erfindung sind in den Unteransprüchen angegeben.

Eine Schaltungsanordnung nach der Erfindung wird anhand einer Zeichnung nachfolgend und beispielsweise beschrieben. Es zeigen:

Fig. 1    eine Reihenschaltung eines Kopfhörers mit einem temperaturabhängigen
         Widerstand

Fig. 2    eine Parallelschaltung eines Kopfhörers mit einem temperaturabhängigen
         Widerstand

Fig. 3    eine Reihen- und Parallelschaltung ei-
         nes Kopfhörers mit einem temperatur-
         abhängigen Widerstand

Fig. 4    einen Kopfhörer mit einer Schwingspule aus Draht mit einem positivem
         Temperaturkoeffizienten.

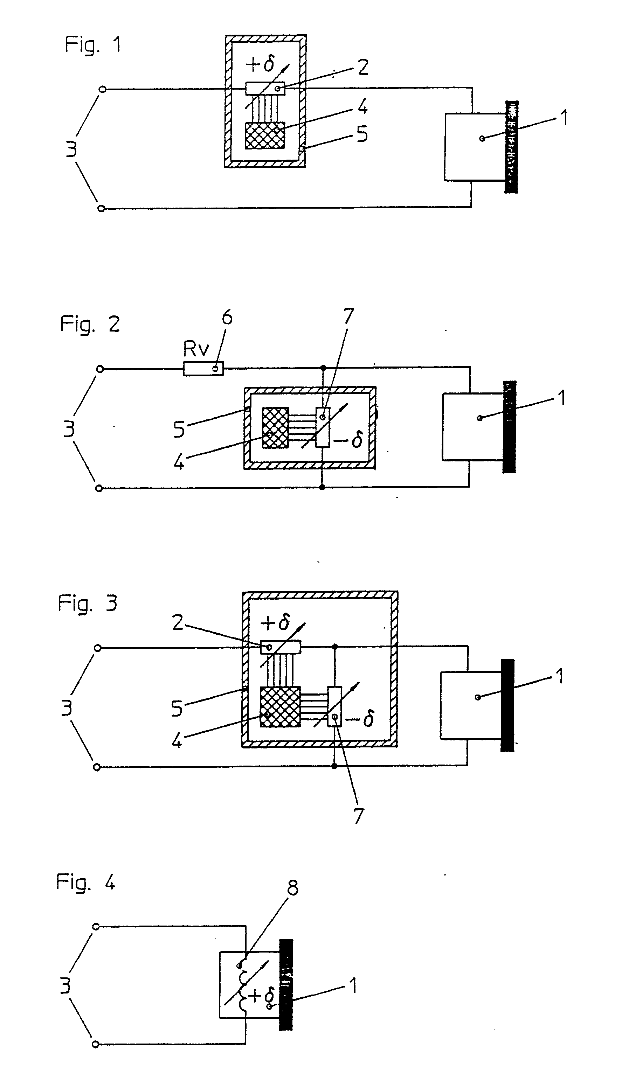

In Figur 1 ist die einfachste Ausführungsform der Erfindung dargestellt. Ein Wiedergabewandler 1 ist über einen Vorwiderstand 2 an die Anschlußklemmen 3 beispielsweise eines NF-Verstärkers abgeschlossen. Der Vorwiderstand 2 hat einen positiven Temperaturkoeffizienten und ist thermisch eng an ein Medium 4 mit hoher Wärmekapazität angekoppelt. Der Vorwiderstand 2 und das Medium 4 sind durch die Wärmeisolierung 5 weitgehend von der Umgebungstemperatur abgekoppelt. Wird an die Klemmen 3 eine NF-Spannung angelegt, so fließt der niederfrequente Strom über den Vorwiderstand 2 und erwärmt denselben umso stärker, je höher die Spannung und damit der Strom ist. Durch den positiven Temperaturkoeffizienten vergrößert sich der Wert des Vorwiderstandes 2 und die Spannung am Wiedergabewandler 1 wird geringer, d.h. die Lautstärke geht zurück. Durch eine geeignete Dimensionierung des Vorwiderstandes 2 und des wärmespeichernden Mediums kann schon eine gute Annäherung an die TTS-Kurven erreicht werden. Ein derartiger Kopfhörer wird zu Beginn relativ hohe Schallpegel abgeben. die sich aber mit zunehmender Abhörzeit durch die Aufheizung des Vorwiderstandes 2 in Abhängigkeit der Wärmekapazität des wärmespeichernden Mediums 4 stetig verringert. Dabei wird zwar die Lautstärke erfindungsgemäß herabgesetzt, nicht aber die Dynamik des übertragenen Signals.

Eine andere Ausführungsform ist in Figur 2 gezeigt. Hier hat der mit einem wärmespeichernden Medium 4 gekoppelte temperaturabhängige Widerstand 7 einen negativen Temperaturkoeffizienten und ist dem Kopfhörer 1 parallel geschaltet. Diese Parallelschaltung ist mit einem praktisch temperaturunabhängigen Widerstand 6 an die Anschlußklemmen 3 angeschlossen. Auch hier heizt der niederfrequente Strom den temperaturabhängigen Widerstand 7 und das Wärmespeichermedium 4 auf; durch den sich verringernden Widerstandswert nimmt die Spannung an dem Kopfhörer aufgabengemäß ab.

Die Figur 3 zeigt eine Kombination der Figuren 1 und 2, wobei die beiden temperaturabhängigen Widerstände 5 und 7 mit jeweils entgegengesetztem Temperaturkoeffizienten in Zusammenhang mit der Wärmekapazität des wärmespeichernden Mediums eine verbesserte Abstimmung auf den gewünschten TTS-Kurvenverlauf ermöglichen.

Eine weitere Ausgestaltung der Erfindung zeigt die Figur 4. Hier ist bei einem Wiedergabewandler 1 die Schwingspule 8 selbst aus einem Draht mit positivem Temperaturkoeffizienten gewickelt. Bei ausreichender Wärmekapazität der Spule wird hier auch eine zeitabhängige Verringerung der Lautstärke durch die Erhöhung des Schwingspulenwiderstandes erreicht.

Werden zwei Wiedergabewandler zu einem Kopfhörer vereinigt, so ist es zweckmäßig, sämtliche temperaturabhängigen Widerstände der Dämpfungsnetzwerke miteinander thermisch zu koppeln, um die Balance zu erhalten. Ohne diese Maßnahme kann die Balance dann gestört werden, wenn die Wiedergabewandler für die rechte bzw. linke Kopfseite längere Zeit mit unterschiedlichen Signalpegeln beaufschlagt werden.

Durch ein mit einer Zeitkonstanten nach der Erfindung ausgebildeten Dämpfungsnetzwerk wird gegenüber bekannten Schaltungen die Wiedergabedynamik nicht eingeschränkt, jedoch ein über längere Zeit schädlich wirkender Schallpegel am Ohr des Benutzers vermieden.

**Patentansprüche**

1. Schaltungsanordnung zur Begrenzung der Lautstärke eines dynamischen Wiedergabewandlers mittels eines diesem vorgeschalteten passiven Dämpfungsnetzwerks mit mindestens einem temperaturabhängigen Widerstand, **dadurch gekennzeichnet,** daß der von der Lautstärke und der Einwirkungszeit derselben abhängige Dämpfungsverlauf des Dämpfungsnetzwerks eine Zeitkonstante aufweist, welche durch die Wärmespeicherkapazität des temperaturabhängigen Widerstandes selbst oder durch ein mit demselben thermisch gekoppeltes wärmespeicherndes Medium gebildet wird.

2. Dämpfungsnetzwerk für eine Schaltungsanordnung nach Anspruch 1, **gekennzeichnet durch** einen in Reihe mit dem Wiedergabewandler geschalteten temperaturabhängigen Widerstand mit positiven Temperaturkoeffizienten.

3. Dämpfungsnetzwerk für eine Schaltungsanordnung nach Anspruch 1, **dadurch gekennzeichnet,** daß ein parallel zum Wiedergabewandler geschalteter temperaturabhängiger Widerstand mit negativem Temperaturkoeffizienten einen Spannungsteiler mit einem in Reihe geschalteten Vorwiderstand $R_V$ und/oder dem Innenwiderstand einer Ansteuerschaltung bildet.

4. Dämpfungsnetzwerk nach Anspruch 3, **dadurch gekennzeichnet,** daß der in Reihe geschaltete Vorwiderstand $R_V$ durch einen temperaturabhängigen Widerstand mit positivem Temperaturkoeffizienten gebildet wird.

5. Dämpfungsnetzwerk nach Anspruch 4, **dadurch gekennzeichnet,** daß beide temperaturabhängigen Widerstände durch ein gemeinsames wärmespeicherndes Medium thermisch gekoppelt sind.

6. Dämpfungsnetzwerk für eine Schaltungsanordnung, nach einem der vorhergehenden Ansprüche, **dadurch gekennzeichnet,** daß die temperaturabhängigen Widerstände beziehungsweise deren wärmespeichernden Medien zur Umgebung hin mittels einer Wärmedämmung thermisch isoliert sind.

7. Dämpfungsnetzwerk für eine Schaltungsanordnung nach Anspruch 1, **dadurch gekennzeichnet,** daß der Wicklungswiderstand der Schwingspule des Wandlers einen positiven Temperaturkoeffizienten aufweist und die Schwingspule selbst, gegebenenfalls in Verbindung mit dem Schwingspulenkörper die Wärmekapazität bildet.

8. Dämpfungsnetzwerk nach einem der vorhergehenden Ansprüche,
   **dadurch gekennzeichnet,**
   daß die durch die Zeitkonstante und die temperaturabhängigen Eigenschaften der Widerstände bestimmte Dämpfung annähernd reziprok der TTS-Kurve des menschlichen Ohres verläuft.

9. Kopfhörer mit jeweils mindestens einem rechten und einem linken Wiedergabewandler, welchen Dämpfungsnetzwerke nach einem der vorhergehenden Ansprüche vorgeschaltet sind,
   **dadurch gekennzeichnet,**
   daß sämtliche temperaturabhängigen Widerstände der Dämpfungsnetzwerke miteinander thermisch gekoppelt sind.

Fig. 1

Fig. 2

Fig. 3

Fig. 4

**Europäisches Patentamt**

# EUROPÄISCHER RECHERCHENBERICHT

Nummer der Anmeldung

**EP 91 10 8917**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-2 237 448 (REINHARD)<br>* Anspruch; Abbildung 2 *<br>– – – | 1,2 | H 04 R 3/00<br>H 03 G 1/00<br>H 03 G 3/20 |
| A | FR-A-2 347 847 (DUAL GEBRUDER STEIDINGER)<br>* Seite 3, Zeile 8 - Seite 4, Zeile 20; Abbildung *<br>– – – | 1,2 | |
| A | US-A-3 943 411 (HUSZTY ET AL.)<br>* Spalte 7, Zeile 1 - Zeile 25; Abbildung 1 *<br>– – – | 3,4 | |
| A | US-A-4 864 624 (TICHY)<br>– – – – – | | |

| RECHERCHIERTE SACHGEBIETE (Int. Cl.5) |
|---|
| H 04 R<br>H 03 G |

Der vorliegende Recherchenbericht wurde für alle Patentansprüche erstellt

| Recherchenort | Abschlußdatum der Recherche | Prüfer |
|---|---|---|
| Den Haag | 24 September 91 | LAMBLEY S.J. |